Europäisches Patentamt

European Patent Office

Office européen des brevets

(11) Publication number: **0 468 274 A2**

# EUROPEAN PATENT APPLICATION

(21) Application number: **91111411.4**

(22) Date of filing: **09.07.91**

(51) Int. Cl.5: **G03F 1/08**

(30) Priority: **12.07.90 JP 184620/90**

(43) Date of publication of application:
**29.01.92 Bulletin 92/05**

(84) Designated Contracting States:
**DE FR GB**

(71) Applicant: **Kabushiki Kaisha Toshiba**
**72, Horikawa-cho Saiwai-ku**
**Kawasaki-shi(JP)**

Applicant: **TOSHIBA MICRO-ELECTRONICS**
**CORPORATION**
**25-1, Ekimaehoncho**
**Kawasaki-ku Kawasaki-shi(JP)**

(72) Inventor: **Suzuki, Toshiyuki, c/o Intellectual**
**Property Div.**
**Kabushiki Kaisha Toshiba, 1-1 Shibaura**
**1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **Method of forming an electrode on a mask for manufacturing semiconductor devices, spinner for applying resist to a semiconductor-manufacturing mask, and mask-housing case.**

(57) In a method of forming an electrode on a mask for manufacturing semiconductor devices according to this invention, part of the surface of the conducting film (12) is masked with masking material (32) and then resist is applied to it. Because the masked part has not been coated with the resist, the conducting film is exposed there. The exposed conducting film is used as an electrode.

F I G. 9B

This invention relates to a method of forming electrodes on a mask for manufacturing semiconductor devices, a spinner, and a mask-housing case.

Thin-film etching by a photoetching method is now indispensable for LSI manufacturing technology.

In photoetching techniques, a mask on which patterns including interconnections have been written is used. In a stepper, PLA, or the like, by using such a mask, photoresist on the thin film of, for example, polysilicon is exposed to light. Then, the exposed parts or unexposed parts are removed to form a photoresist pattern on the thin film. Using the photomask pattern as mask, the thin film is then etched.

The way of forming a desired mask is now explained.

First, on the surface of a plate made of insulating, transparent material, such as glass or quartz, what is called a mask blank is placed which is covered with a light-screening film made of chromium or the like.

Electron-beam resist (e.g., polymethyl methacrylate) is then applied to the mask blank and a particular pattern is produced on the resist by electron-beam lithography.

Next, the lithographed resist is developed and the resulting resist pattern is used as a mask, with which the light-screening film of chromium or the like is etched to form a light-screening film pattern. After this, the resist pattern is removed.

After passing through the foregoing steps, the mask is completed.

In conventional electron-beam lithography, however, the electron beam, which basically consists of charged particles, creates the problem of the resist being charged.

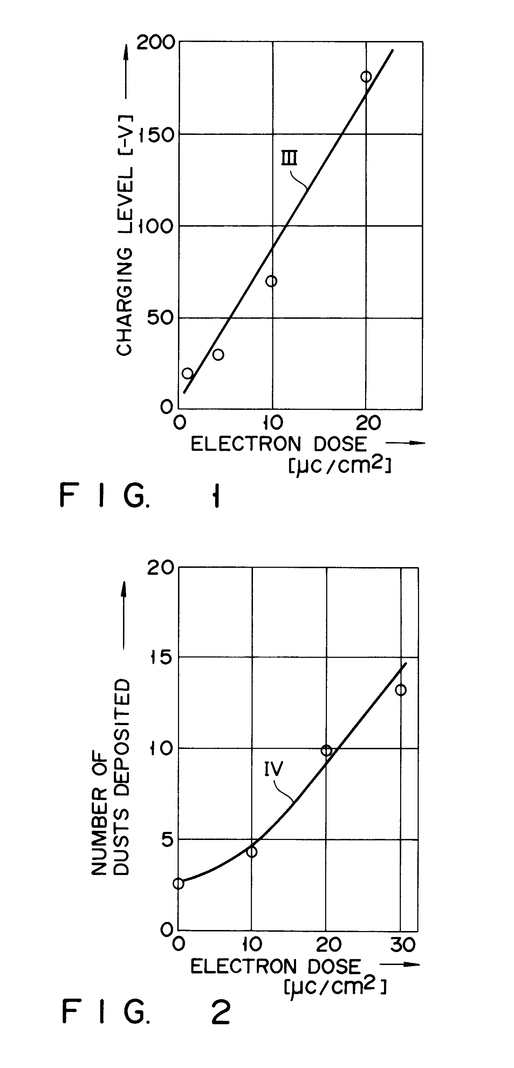

Fig. 1 shows the relationship between the dose level of electron beam and the amount of charge on the resist.

Experiment has shown that the amount of charge on the resist tends to increase with the dose level of electron beam as illustrated by line III in Fig. 1.

Fig. 2 shows the relationship between the dose level of electron beam and the amount of dust deposited on the resist.

Tests have revealed that the amount of dust attached to the resist increases with the dose level of electron beam as indicated by line IV in Fig. 2.

That is, the charged resist attracts dust (also known as scum) from its vicinities.

To overcome this problem, a lithography method has been proposed which permits a grounded electrode to be in contact with the chromium film on the mask blank, thereby performing electron-beam lithography with the mask blank being grounded (reference: Published Unexamined Japanese Patent Application No. 2-103046). In this method, the resist film is exposed to electron beam with the mask blank grounded, so that the resist film is not charged.

With this method, however, to allow the grounded electrode to make contact with the chromium film, it is necessary to remove part of the resist to expose the chromium film, meaning that an electrode must be formed on the mask blank for contact with the grounded electrode. Formation of such an electrode requires two steps: a step of applying resist to the mask blank, and the subsequent step of removing part of the resist. Consequently, by the method disclosed in the above reference, an increase in the number of steps is inevitable.

It is an object of the present invention to provide a method of forming an electrode on a mask for manufacturing semiconductor devices which can avoid the problem of increasing the processing steps.

This object is accomplished by a method comprising the steps of: masking part of a conducting film formed on the main surface of the substrate with masking material, and then applying resist to the conducting film.

With this method, part of the conducting film is covered with masking material, which creates a portion in the resist film from which the conducting film appears. The exposed part of the conducting film can be used as an electrode on the mask blank. Therefore, a lithography method as disclosed in Published Unexamined Japanese Patent Application No. 2-103046 can be achieved without increasing processing steps.

Another object of the present invention is to provide a spinner (a rotary coating machine) capable of achieving the above-mentioned electrode-forming method.

This object is accomplished by an arrangement where a stage, on which a mask for manufacturing semiconductor devices is placed, is provided with a masking member that covers part of the mask.

This invention can be more fully understood from the following detailed description when taken in conjunction with the accompanying drawings, in which:

Fig. 1 shows the relationship between the dose level of electron beam and the amount of charge on the resist;

Fig. 2 shows the relationship between the dose level of electron beam and the amount of dust deposited on the resist;

Figs. 3 through 5 are perspective views for semiconductor manufacturing masks according to embodiments of the present invention;

Fig. 6 illustrates how a semiconductor manufacturing mask according to an embodiment of the present invention is exposed to electron beam;

Figs. 7 and 8 show the relationship between the amount of charge on the resist and the time elapsed after electron-beam radiation;

Figs. 9A through 9G are perspective views illustrated in manufacturing sequence for the method of forming a mask for manufacturing semiconductor devices according to the present invention;

Fig. 10 is a plan view for a first example of a spinner according to an embodiment of the present invention;

Fig. 11 is a sectional view taken along line 11-11 of Fig. 10;

Fig. 12 is a plan view for a second example of a spinner according to an embodiment of the present invention;

Fig. 13 is a sectional view taken along line 13-13 of Fig. 12;

Fig. 14 is a plan view for a third example of a spinner according to an embodiment of the present invention;

Fig. 15 is a sectional view taken along line 15-15 of Fig. 14;

Fig. 16 is a sectional view for a first example of a housing case according to an embodiment of the present invention; and

Fig. 17 is a sectional view for a second example of a housing case according to an embodiment of the present invention.

Referring to the accompanying drawings, a method of forming an electrode on a semiconductor-manufacturing mask according to an embodiment of the present invention will be explained. Like parts throughout the drawings are indicated by like reference characters to avoid the repetition of the same explanation.

Figs. 3 through 5 are perspective views for masks formed by a method for forming an electrode according to an embodiment of the present invention.

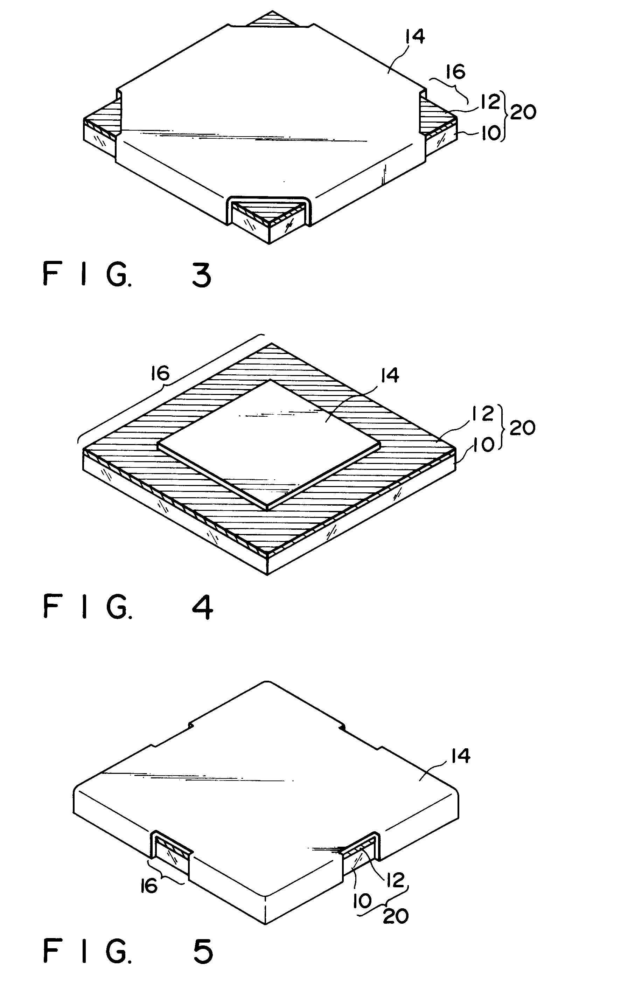

As shown in Figs. 3 through 5, on a plate 10 made of insulating, transparent material, such as glass or quartz, a light-screening, conducting film 12 such as a chromium film is formed. A mask on which the light-screening film pattern has not yet been formed is specially called a mask blank. On the chromium film 12, a resist film 14 made of electron-resist (e.g., polymethyl methacrylate) is formed so as to allow part 16 of the chromium film 12 to be exposed. Providing that at least part of the chromium film 12 is exposed, the exposed portion 16 may be formed into various shapes, for example, as shown in Figs. 3 through 5: the four corners of the mask blank 20 (Fig. 3), the periphery of the mask blank 20 (Fig. 4), and side portions of the mask blank 20 (Fig. 5). Because there is no resist film 14 on the exposed portion 16, the portion 16 is formed outside the area in which a pattern is produced.

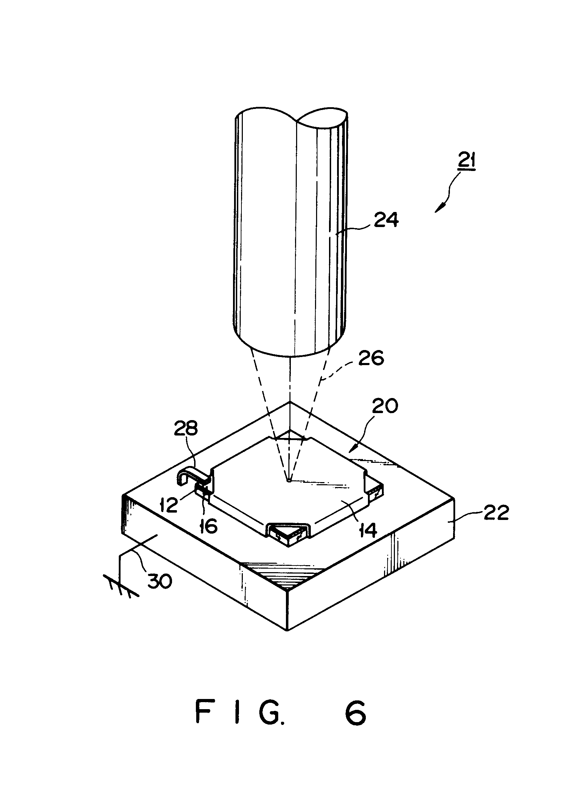

For example, Fig. 6 illustrates how the resist film 14 is exposed to an electron beam using the mask blank 20 of Fig. 3.

As shown in Fig. 6, the mask blank 20 with the exposed portions of the chromium film 16 is placed on the stage 22 of the electron-beam lithography system 21. The electron beam 26 from the electron optical system 24 containing a beam source is radiated onto the resist film 14 on the mask blank 20 for lithography. This electron-beam lithography is performed with one exposed portion of the chromium film 12 in contact with a terminal 28 installed on the stage 22. The terminal 28 is electrically connected to the stage 22, which is connected to the earth via a wire 30, thereby causing the potential of the terminal 28 to be the same as the ground potential. With this arrangement, the resist film 14 undergoes electron-beam lithography with the mask blank 20 grounded. As a result, the radiation of electron beam 26 onto the mask blank 20 will not charge the mask blank 20, particularly the resist film 14.

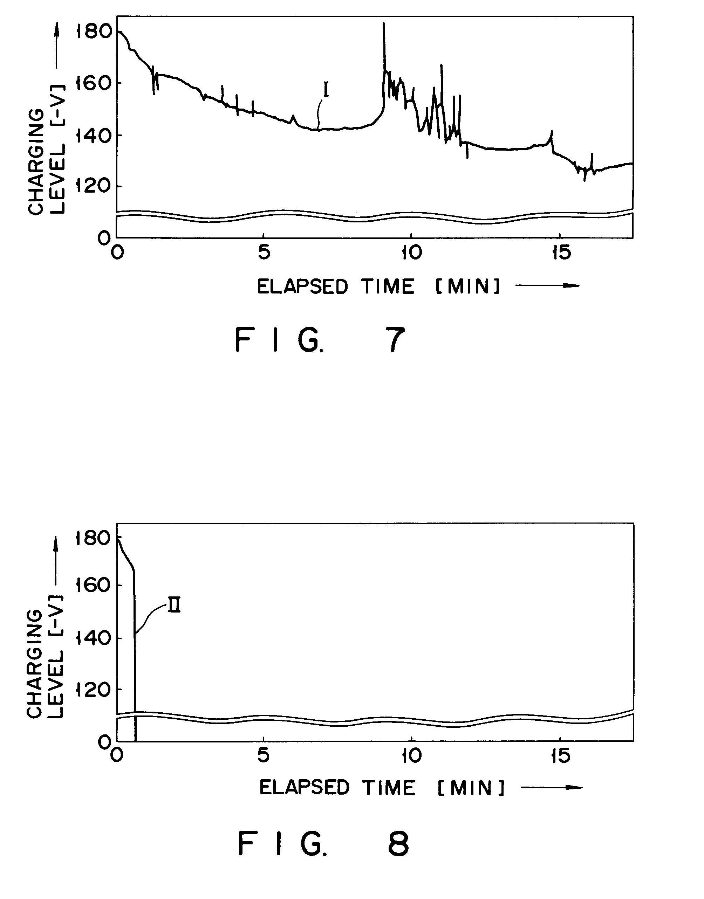

Figs. 7 and 8 show the relationship between the amount of charge on the resist and the time elapsed after electron-beam radiation.

Fig. 7 represents the results of electron-beam lithog-raphy with the mask blank 20 ungrounded, whereas Fig. 8 indicates the results of electron-beam lithography with mask blank 20 grounded.

As seen from line I in Fig. 7, the ungrounded mask blank 20 allows the resist to be charged for a long time.

In contrast, as shown by line II in Fig. 8, the grounded mask 20 prevents the resist from being charged or, even if the resist is charged, causes the charged particles on the resist to be removed in a short time.

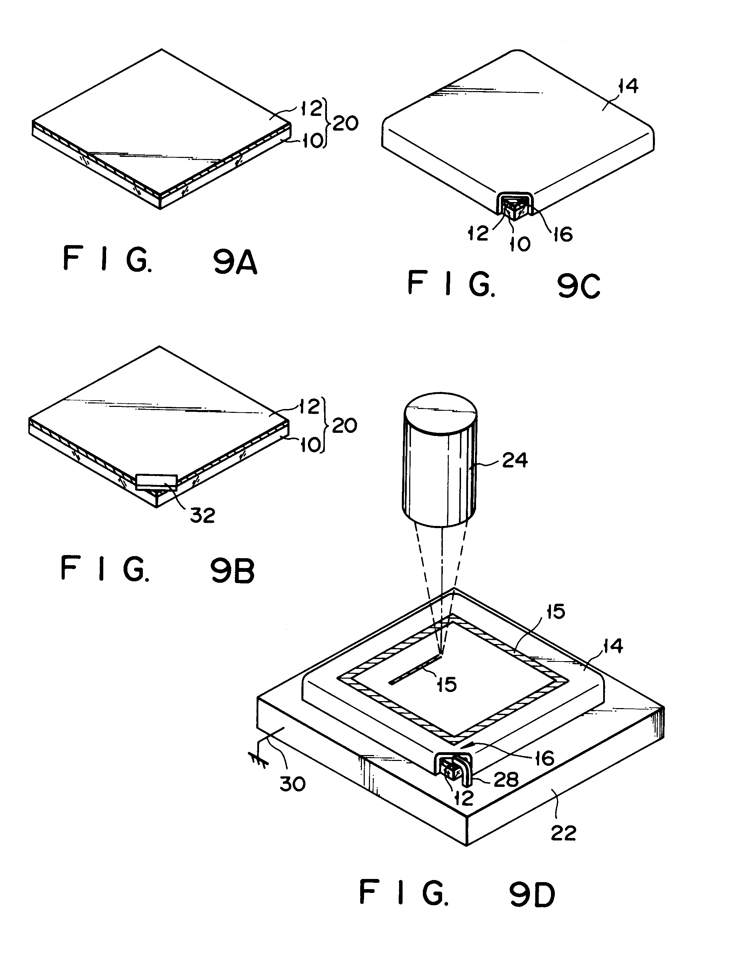

Referring to Figs. 9A through 9G, how to form an electrode on the mask according to the present invention is now described. Figs. 9A through 9G are perspective views illustrating a method of manufacturing a mask in processing sequence.

First, a mask blank 20 is prepared which essentially consists of a chromium film 12 on a plate 10 made of, for example, glass (Fig. 9A).

Part of the chromium film 12 is then masked with a masking material 32 (Fig. 9B).

Next, resist sensitive to electron beam is applied onto the chromium film 12 to form an approximately 6000Å-thick resist film 14. At this time, that part of the chromium film 12 covered with the masking material 32 has not been coated with the resist, so that the part constitutes the exposed portion 16 of the chromium film (Fig. 9C). After this, the resist film 14 is baked at a temperature higher than the glass transition point of the resist.

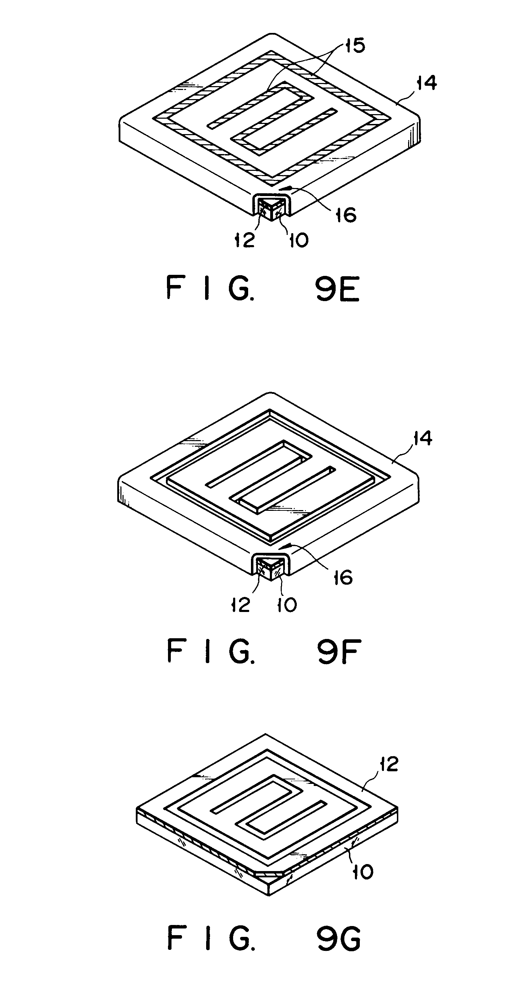

The resist film 14 undergoes lithography by electron beam 26 (Fig. 9D), which produces an exposure pattern 15 in the resist film 14 (Fig. 9E). As described in Fig. 6, exposure of the resist film 14 to electron beam 26 is carried out with the exposed portion 16 of the chromium film 12 in contact with the grounded terminal 28.

Next, the resist film 14 is developed (Fig. 9F) to etch the exposure pattern 15. After the development, to remove the scum, the resist film 14 is rinsed and then baked.

Using the remaining resist film 14 on the chromium film 12 as a mask, the chromium mask is etched, followed by the removal of the resist film 14. This completes the mask made of the chromium film 12 with a light-screening film pattern (Fig. 9G).

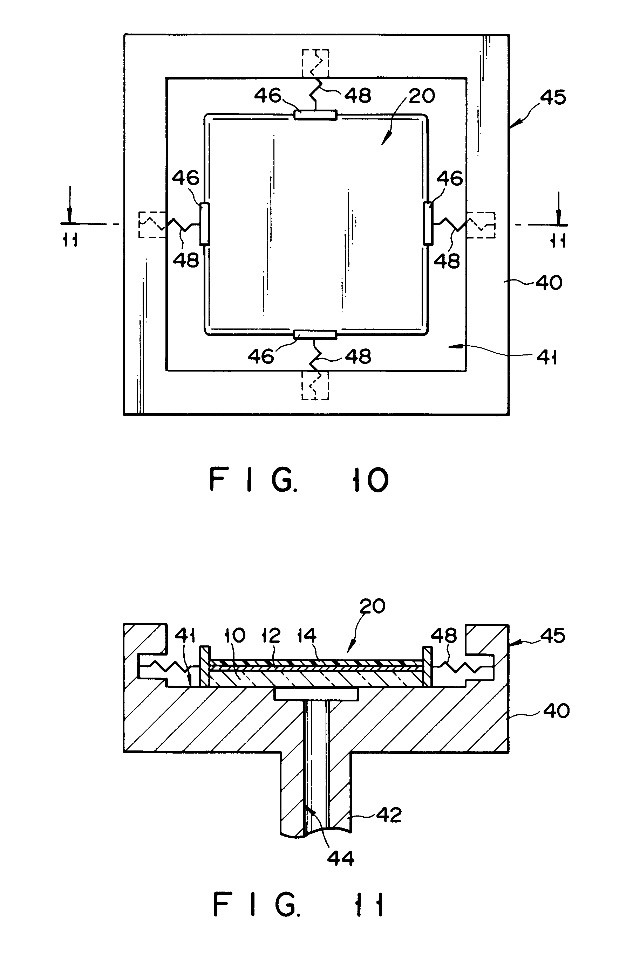

A spinner capable of forming the resist film 14 with the exposing portion 16 of Figs. 3 through 5 will now be explained, referring to Figs. 10 through 15.

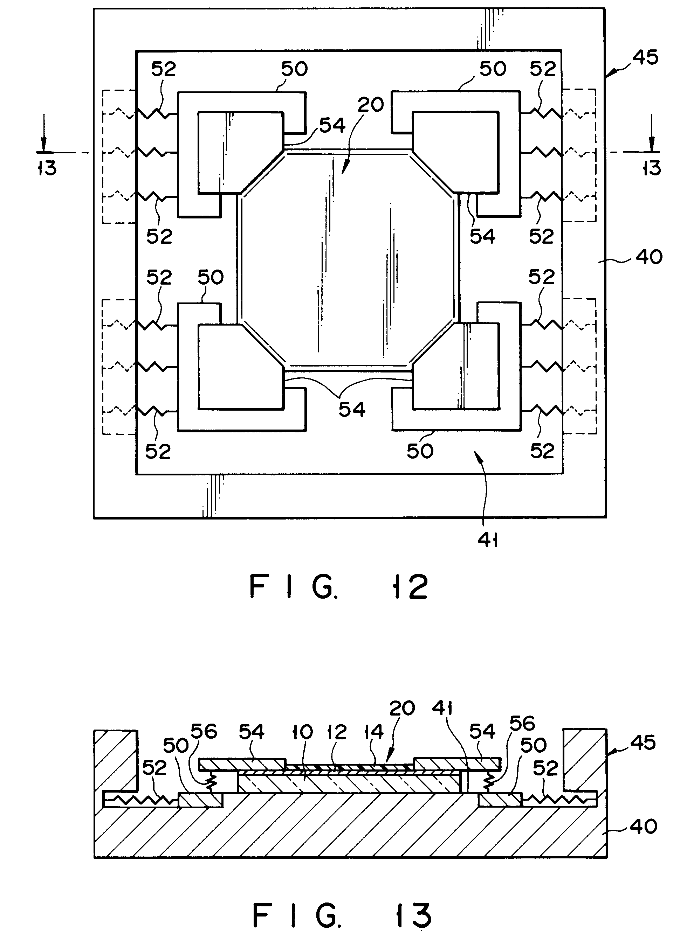

Fig. 10 is a plan view for a first example of a spinner according to an embodiment of the present invention, and Fig. 11 is a sectional view taken along line 11-11 of Fig. 10.

As shown in Figs. 10 and 11, installed on a table 40 is a stage 41, around which a sidewall 45 is formed. Connected to the table 40 is a rotating shaft 42, inside which a vacuum absorption hole 44 is provided. The mask blank 20 is placed above the opening of the vacuum absorption hole 44 and on the stage 41. To the near mid-point of each side wall, an elastic element 48 made up of, for example, a spring is attached. To the tip of the elastic element 48, a holding member 46 is installed. The elastic element 48 is connected to, for example, a device (not shown) that expands and contracts the elastic element 48 as directed by the operator, or a device (not shown) that detects the mask blank 20 being placed on the stage 41 and then expands and contracts the elastic element 48. In the latter case, the installation of the mask blank 20 on the stage 41 is detected by, for example, a sensor (not shown) and then the elastic element 48 is caused to expand from the sidewall 45 so that the holding member 46 may come into contact with the sidewall of mask blank 20. In this state, resist is allowed to drop, while the table 40 is being rotated by the rotating shaft 42 driven by a motor (not shown) so that the resist be applied to the mask blank 20 to form a resist mask 14. At this time, the sidewall of the mask blank 20 is in contact with the holding member 46, so that the contact portion has not been coated with the resist. As a result, the resist mask 14 with the portion 16 at which the chromium film 12 is exposed can be obtained as shown Fig. 5.

The elastic element 48 may be composed of a hydraulic mechanism or the like other than a spring.

Fig. 12 is a plan view for a second example of a spinner according to an embodiment of the present invention, and Fig. 13 is a sectional view taken along line 13-13 of Fig. 12.

As shown in Figs. 12 and 13, a moving element 50 supported by the elastic element 52 is installed on the table so as to correspond to each of the four corners of the mask blank 20. The moving element 50 moves horizontally along the table 40. The elastic element 52 is attached to the sidewall 45. Above the moving element 50, a holding member 54 is provided which is supported by an elastic element 56 so as to move vertically. As with the first example, the elastic elements 52 and 56 are connected to a device (not shown) that expands and contracts these elements 52 and 56 as directed by the operator or a device (not shown) that detects the installation of the mask blank 20 on the table 40 and then expands and contracts the elements 52 and 56. In the latter case, when a sensor (not shown) or the like senses that the mask blank 20 has been placed on the stage 41, then the elastic element 52 expands so as to move the moving element 50 horizontally to a specified position. At the position, the elastic element 56 is contracted so as to move the holding member 54 vertically until the members 54 come into contact with the four corners of the mask blank 20. In this state, resist is allowed to drop, while the base 40 is being rotated by a motor (not shown) so as to allow the resist to be applied for the formation of the resist film 14. As a result, the resist film 14 that allows the chromium film 12 to appear at the four corners of the mask blank 20 can be obtained.

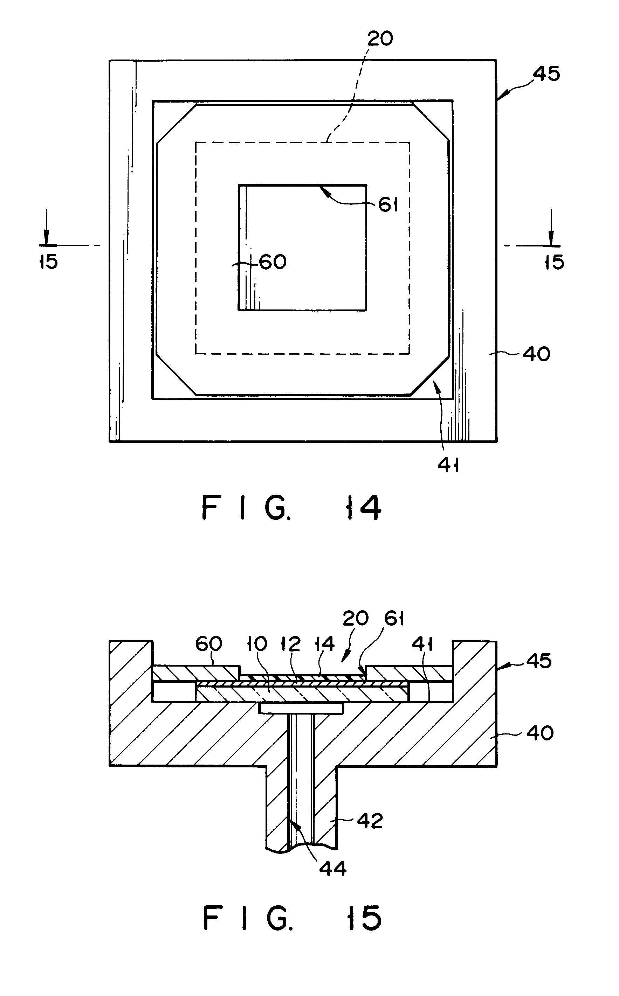

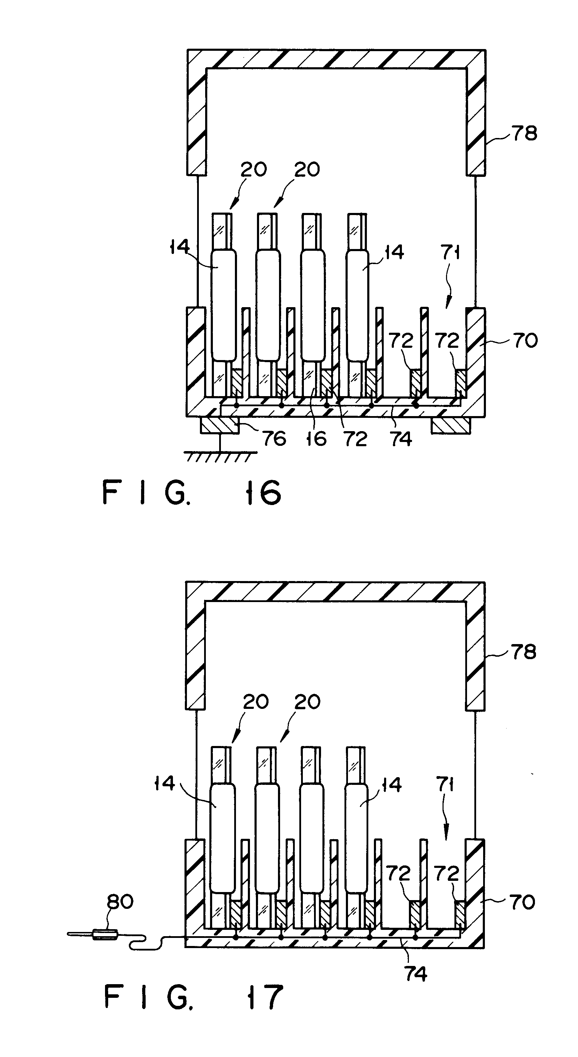

Fig. 14 is a plan view for a third example of a spinner according to an embodiment of the present invention, and Fig. 15 is a sectional view taken along line 15-15 of Fig. 14.

As shown in Figs. 14 and 15, a cover 60 is provided which covers the mask blank 20. In the center of the cover 60, an opening 61 is provided. After the mask blank 20 has been placed on the table 40, for example, the cover 60 is moved as directed by the operator or is placed on the mask blank 20 by a manipulator after it has detected the installation of the mask blank 20 on the table 40. In this state, resist is allowed to drop while the table 40 is being rotated by a motor so as to allow the resist to be applied to form the resist film 14. As a result, the resist film 14 is obtained which allows the chromium film 12 to appear in the periphery of the mask blank 20 of Fig. 4.

As explained above, in this invention, since part of the chromium film is covered in applying resist to the chromium film on the mask blank, an exposed portion of the chromium film is obtained after the application of resist. In performing a lithography technique, for example, as disclosed in Published Unexamined Japanese Patent Application No. 2-103046, the exposed chromium film can be used as an electrode on the mask blank. Therefore, the electrode can be formed on the mask blank just by applying resist.

In addition to acting as an electrode to discharge the accumulated charge in exposing the resist film 14 to electron beam, the exposed portions 16 of the chromium film 12, which the semiconductor manufacturing mask according to this invention has, are also used for other various purposes.

As an example of usage, a housing case to house masks for manufacturing semiconductor devices will explained hereinafter.

Fig. 16 is a sectional view for a first example of a housing case according to an embodiment of the present invention. Fig. 17 is a sectional view for a second example of a housing case according to an embodiment of the present invention.

As shown in Fig. 16, the housing case 70 contains a compartment divided into a plurality of housing sections. These housing sections 71 each house mask blanks 20. Each housing section 71 is provided with a terminal 72, which is in contact with the exposed portion 16 when the mask blank 20 is in the housing section. Each terminal 72 is connected to an interconnection 74, which is connected to, for example, a leg 76 on the bottom surface of the housing case. The leg 76 also serves as ground electrode, which causes the interconnection 74 to be at the ground potential, thereby bringing the terminal 72 to the ground potential.

With the housing case of such an arrangement, the exposed portion 16 of the chromium film 12 can be housed while being in contact with the terminal 72. This permits the electrostatic charge to discharge even when the mask blank 20 is charged from rubbing against the case. That is, the rubbing of the mask blank against the case will not charge itself, particularly the resist film 14. Thus, during the action of housing the mask blank 20 in the case or its storage, attachment of dust to the mask blank 20 can be prevented. In Fig. 16, the portion indicated by reference character 78 is a lid of the housing case 70.

Fig. 17 shows another mode of the housing case. As illustrated here, the interconnection is connected to a plug 80. The plug 80 may be connected to a jack (not shown) receiving a specified potential.

While the housing cases in Figs. 16 and 17 house mask blanks 20 on which resist films 14 have been formed, they may house other similar things. For example, they may house mask blanks without resist films 14 or semiconductor-device manufacturing masks practically used in LSI photolithography processing. In both cases, the accumulation of charge accompanying the attachment of dust can, of course, be suppressed.

## Claims

1. A method for forming an electrode on a mask for manufacturing semiconductor devices, characterized by comprising the steps of:

   masking part of a conducting film (12) on the main surface of a substrate (10) with masking material (21, 46, 54, 60); and

   applying resist to said conducting film (12) to form a resist film (14) so that an exposed portion (16) of said conducting film (12) may appear at said masked portion.

2. A method according to claim 1, characterized that said step of masking part of a conducting film (12) on the main surface of a substrate (10) with masking material (21, 46, 54, 60) is achieved by masking the four corners of the conducting film with the masking material (21, 46, 54, 60).

3. A method according to claim 1, characterized that said step of masking part of a conducting film (12) on the main surface of a substrate (10) with masking material (21, 46, 54, 60) is achieved by masking the periphery of the conducting film with the masking material (21, 46, 54, 60).

4. A method according to claim 1, characterized that said step of masking part of a conducting film (12) on the main surface of a substrate (10) with masking material (21, 46, 54, 60) is achieved by masking the sidewall of the conducting film on and over the substrate with the masking material (21, 46, 54, 60).

5. A spinner comprising a supporting table (40) having a stage (41) on which a mask blank (20) is placed, and a shaft (42) attached to the supporting table (40), characterized in that:

   said stage (41) is provided with masking means (46, 54, 60) for masking part of said mask (20) for manufacturing semiconductor devices.

6. A case comprising a housing section (71) for housing a conducting film (12)-covered mask (20) for manufacturing semiconductor devices, characterized in that:

   said housing section (71) is provided with a terminal (72) to which a specified potential is applied.

7. A case according to claim 6, characterized in that said mask (20) for manufacturing semiconductor devices is housed in said housing section (71) so that the conducting film (12) covering the surface of the mask may be in contact with said terminal (72).

8. A case according to claim 6, characterized in that said specified potential is the ground potential.

F I G. 1

F I G. 2

F I G. 3

F I G. 4

F I G. 5

F I G. 6

F I G. 7

F I G. 8

FIG. 9A

FIG. 9B

FIG. 9C

FIG. 9D

F I G. 9E

F I G. 9F

F I G. 9G

F I G. 10

F I G. 11

FIG. 12

FIG. 13

F I G. 14

F I G. 15

F I G. 16

F I G. 17